# EUROPÄISCHE PATENTANMELDUNG

(11) **EP 3 648 351 A1**
(43) Veröffentlichungstag der Anmeldung: **06.05.2020**
(21) Anmeldenummer: 19205776.8
(22) Anmeldetag: 29.10.2019
(51) Int. Cl.: H03K 17/96, H03K 17/955

(54) **SCHALTELEMENT**

(30) Priorität: 30.10.2018 DE 102018008481
(71) Anmelder: Marquardt GmbH, 78604 Rietheim-Weilheim (DE)
(72) Erfinder: Lehr, Steffen, 78050 Villingen-Schwenningen (DE); Riesenberg, Jens, 42369 Wuppertal (DE)
(74) Vertreter: Otten, Roth, Dobler & Partner mbB Patentanwälte

(57) **Zusammenfassung**

Die Erfindung betrifft ein Schaltelement (1) mit einem Sensor (4) und mit einem beweglichen Betätigungselement (5). Das Betätigungselement (5) wirkt mit dem Sensor (4) innerhalb eines Betätigungsbereichs (6) zur Erzeugung eines Signals in der Art eines Schaltsignals zusammen. Der Sensor (4) ist als ein kapazitiver Sensor ausgebildet und umfasst zwei Elektroden (7, 8), wobei eine elektrische Spannung an die Elektroden (7, 8) zur Ausbildung eines elektrischen Kondensators anlegbar ist. Die Kapazitätsänderung des von den Elektroden (7, 8) gebildeten Kondensators aufgrund der Bewegung des Betätigungselements (5) in und/oder aus den Betätigungsbereich (6) ist zur Erzeugung des Schaltsignals auswertbar.

## Beschreibung

Die Erfindung betrifft ein Schaltelement nach dem Oberbegriff des Patentanspruchs 1.

Derartige Schaltelemente können in einer Vielzahl von Anwendungen, insbesondere in einem Kraftfahrzeug, eingesetzt werden. Beispielsweise können solche Schaltelemente in Türschlössern für die Seitentür, für die Heckklappe, für die Frontklappe o. dgl. im Kraftfahrzeug zur Detektierung des Zustandes des Türschlosses eingesetzt werden.

Ein solches Schaltelement umfasst einen Sensor und ein bewegliches Betätigungselement. Das Betätigungselement wirkt mit dem Sensor in Bezug auf einen dem Sensor zugeordneten Betätigungsbereich zur Erzeugung eines Signals in der Art eines Schaltsignals zusammen. Als Sensoren werden in herkömmlicher Weise elektrische Schalter, Schnappscheiben o. dgl. verwendet, deren Funktionalität eingeschränkt ist. Des Weiteren sind diese elektrische Schalter, Schnappscheiben o. dgl. einem gewissen Verschleiß unterworfen.

Der Erfindung liegt die Aufgabe zugrunde, das Schaltelement im Hinblick auf eine erweiterte Funktionalität weiterzuentwickeln. Insbesondere soll das Schaltelement im Wesentlichen verschleißfrei betreibbar sein.

Diese Aufgabe wird bei einem gattungsgemäßen Schaltelement durch die kennzeichnenden Merkmale des Anspruchs 1 gelöst.

Beim erfindungsgemäßen Schaltelement ist der Sensor als ein kapazitiver Sensor ausgebildet. Der Sensor umfasst zwei Elektroden, wobei eine elektrische Spannung an die Elektroden zur Ausbildung eines elektrischen Kondensators anlegbar ist. Zur Erzeugung des Signals ist die Kapazitätsänderung des von den Elektroden gebildeten Kondensators aufgrund der Bewegung des Betätigungselements relativ zum Betätigungsbereich auswertbar. In vorteilhafter Weise arbeitet das Schaltelement berührungslos, womit Verschleißerscheinungen weitgehend vermieden sind. Weitere Ausgestaltungen der Erfindung sind Gegenstand der Unteransprüche.

In weiterer Ausgestaltung kann das Signal bei der Bewegung des Betätigungselements in den Betätigungsbereich und/oder innerhalb des Betätigungsbereichs erzeugt werden. In entsprechender Weise ist es auch möglich, dass das Signal bei der Bewegung des Betätigungselements aus dem Betätigungsbereich und/oder außerhalb des Betätigungsbereichs erzeugt wird. Diese Ausgestaltungen zeichnen sich durch eine einfache Auswertung für die Erzeugung des Signals aus.

In kostengünstiger sowie betriebssicherer Art und Weise können die Elektroden als elektrische Leiterbahnen und/oder als elektrische Leiterflächen ausgebildet sein. Der einfachen Montage halber können die elektrischen Leiterbahnen und/oder Leiterflächen auf einem Träger befindlich sein. Als Träger kann beispielsweise in kostengünstiger Weise eine Leiterplatte Verwendung finden.

In einer Ausgestaltung kann die Elektrode eine im Wesentlichen geradlinige Leiterbahn umfassen. Von der im Wesentlichen geradlinigen Leiterbahn kann mindestens ein Leiterbahnabschnitt in der Art eines Zahns abgehen. In bevorzugter Weise kann der Leiterbahnabschnitt im Wesentlichen senkrecht abstehend abgehen. Insbesondere kann dabei die geradlinige Leiterbahn mit dem Leiterbahnabschnitt und/oder den Leiterbahnabschnitten eine Art von Kamm ausbilden. In kompakter Art und Weise können dann die beiden Elektroden mit gegenseitig ineinandergreifenden Leiterbahnabschnitten bzw. Zähnen angeordnet sein. Dadurch ist ein besonders betriebs- und/oder funktionssicher arbeitendes Schaltelement geschaffen.

In einer weiteren Ausgestaltung kann die Elektrode eine kreisförmige und/oder kreisabschnittsförmige und/oder kreisflächenförmige Leiterbahn und/oder Leiterfläche umfassen. In kompakter Art und Weise können die beiden Elektroden konzentrisch zueinander angeordnet sein.

Das Betätigungselement kann in einfacher Weise als ein flächenhaftes Element ausgebildet sein. Insbesondere kann das flächenhafte Element rechteckförmig ausgestaltet sein. Je nach Einsatzzweck kann das Betätigungselement aus Kunststoff und/oder aus Metall bestehen.

Zum Schutz vor äußeren Einflüssen auf den Sensor kann ein Gehäuse vorgesehen sein. In kompakter Art kann das Gehäuse in der Art und/oder mit der Form eines Mikro- und/oder Schnappschalters ausgebildet sein. Vorteilhafterweise lassen sich dann die herkömmlich vorgesehenen, elektrischen Mikro- und/oder Schnappschalter in einfacher Weise durch das erfindungsgemäße Schaltelement ersetzen. Der Träger für die Elektroden, und zwar insbesondere die Leiterplatte, kann im Inneren des Gehäuses angeordnet sein. Das Betätigungselement kann entsprechend dem Einsatzzweck innerhalb und/oder außerhalb des Gehäuses befindlich sein.

In zweckmäßiger Ausgestaltung kann der Sensor eine Schaltungsanordnung für die Messung der Kapazität des von den Elektroden ausgebildeten Kondensators umfassen. Des Weiteren kann die Schaltungsanordnung für die Messung der Kapazität mit einer Elektronik in der Art einer Auswerteschaltung für die Ermittlung der Kapazitätsänderung und/oder zur Erzeugung des Signals, und zwar insbesondere entsprechend der Interpretation der Messwerte des Sensors, in Verbindung stehen. In einfacher Art und Weise kann es sich bei der Elektronik um einen Mikroprozessor handeln. Zwecks Einsparung von Kosten sowie in kompakter Ausgestaltung kann die Schaltungsanordnung für die Messung der Kapazität in die Elektronik integriert sein. Entsprechend dem Einsatzzweck kann die Elektronik außerhalb und/oder innerhalb des Gehäuses angeordnet sein.

Zwecks Steigerung der Funktionalität können mehrere Schaltelemente elektrisch mit der Auswerteschaltung zu einer Schalteranordnung verbunden sein. Eine solche Schalteranordnung umfasst mehrere erfindungsgemäß ausgebildete Schaltelemente. Dabei kann eine einzige Elektronik in der Art eines Steuergeräts, beispielsweise einer Electronic Control Unit (ECU), als Auswerteschaltung für die Schaltelemente vorgesehen sein. Des Weiteren können die Schaltelemente in kostengünstiger Weise mittels eines Bussystems untereinander und/oder mit der Elektronik in Verbindung stehen. Dabei kann es sich anbieten, dass die Elektronik extern in Bezug auf die Schaltelemente angeordnet ist, also insbesondere außerhalb des Gehäuses für das Schaltelement angeordnet ist.

Für eine besonders bevorzugte Ausgestaltung der Erfindung ist nachfolgendes festzustellen.

Es soll der bisherige mechanische Schalter durch einen berührungslosen elektronischen Schalter in Applikationen ersetzt werden. Bei diesen Applikationen geht es insbesondere um Schaltvorgänge, die z.B. durch eine mechanisch bewegliche Komponente ausgelöst werden, nicht jedoch durch einen menschlichen Finger bzw. von Personen. Der Schalter soll berührungslos und damit verschleißfrei sein. Es sollen Systemkosten durch die Reduzierung von Verdrahtungsaufwand eingespart werden, indem die elektronischen Schalter mittels einer Schnittstelle, beispielsweise einer Ein-Draht-Schnittstelle, miteinander verbunden werden. Die Schalteinheit soll diagnosefähig sein. Durch den reduzierten Verdrahtungsaufwand sollen Gewichtseinsparungen erzielt werden. Die Systemkosten sollen reduziert werden.

Hierfür ist ein elektronischer Schalter in der Art eines kapazitiven Näherungsdetektors nach dem "Mutual Kapazitäts-Messprinzip" vorgeschlagen. Eine Reduktion der Drahtverbindungen kann durch die Implementierung eines Ein-Draht Busses auf der Spannungsversorgung erfolgen. Durch die Implementation eines Mikrokontrollers kann jeder Schalter individuell angesprochen werden. Jeder Schalter hat eine individuelle Kennung und kann von der ECU (Electronic Control Unit) identifiziert werden. Ebenso stellt das Kommunikationsprotokoll sicher, dass die Kommunikation geordnet und seriell, insbesondere im Zeitraster, funktioniert.

Geschaffen ist somit ein diagnosefähiger und berührungsloser elektronischer Schalter für Schloss-, Schließ- und Abfrageapplikationen, insbesondere in Kraftfahrzeugen in der Art eines automotiven Standardschalters, sowie für andere bewegliche Anwendungen jeglicher Art mit einer großen Funktionssicherheit und Robustheit. Dieser elektronische Schalter lässt sich insbesondere in folgenden Applikationen einsetzen:
- In Türschlössern, beispielsweise in der Seitentür, in der Heckklappe oder in der Frontklappe.
- In Faltdächern, beispielsweise bei Cabrio-Fahrzeugen.
- In Kofferraumabdeckungen.
- In Sitzzustandserkennungen.
- In Schiebedächern.

Des Weiteren kann der elektronische Schalter in verschiedenen Abfragen von mechanischen Zuständen in Fahrzeugen Verwendung finden.

Die mit der Erfindung erzielten Vorteile bestehen insbesondere darin, dass die Systemkosten für die Applikation reduziert sind. Weiter lässt sich eine Reduktion des Verdrahtungsaufwandes und damit des Gewichtes erreichen. Aufgrund der Diagnosefähigkeit für das Schaltelement ist die Funktionssicherheit gesteigert. Schließlich ist eine Reduktion des Verschleißes erzielbar, da es sich um ein berührungslos arbeitendes Schaltelement handelt.

Ausführungsbeispiele der Erfindung mit verschiedenen Weiterbildungen und Ausgestaltungen sind in den Zeichnungen dargestellt und werden im folgenden näher beschrieben. Es zeigen
- Fig. 1: eine Anordnung von herkömmlichen Schaltelementen in schematischer Darstellung,
- Fig. 2: eine Anordnung von erfindungsgemäßen Schaltelementen in detaillierter Darstellung,
- Fig. 3a: ein einzelnes Schaltelement aus Fig. 2, wobei das Schaltelement in unbetätigtem Zustand befindlich ist,
- Fig. 3b: das Schaltelement aus Fig. 3a, wobei das Schaltelement in betätigtem Zustand befindlich ist,
- Fig. 4a: ein Schaltelement wie in Fig. 3a gemäß einer weiteren Ausführung,
- Fig. 4b: das Schaltelement gemäß der weiteren Ausführung wie in Fig. 3b und
- Fig. 5: die Anordnung wie in Fig. 2 mit dem Schaltelement gemäß einer nochmals weiteren Ausführung.

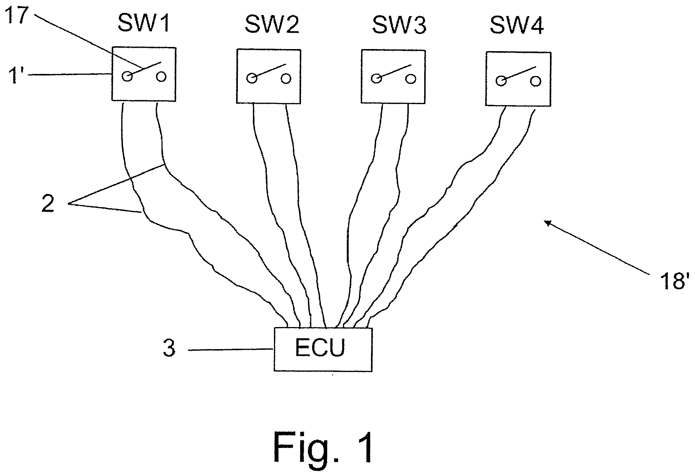

In Fig. 1 ist eine aus mehreren herkömmlichen Schaltelementen SW1, SW2, SW3, SW4 bestehende Anordnung von Schaltelementen 1' zu sehen. Die ein herkömmliches, mechanisches elektrisches Kontaktsystem 17 aufweisenden Schaltelemente 1' sind mittels einzelnen elektrischen Leitungen 2 mit einer Elektronik 3 in der Art einer Steuereinheit (ECU - Electronic Control Unit) verbunden. In solch einer herkömmlichen Schalteranordnung 18' können die Schaltelemente 1' durch erfindungsgemäße Schaltelemente 1 ersetzt werden.

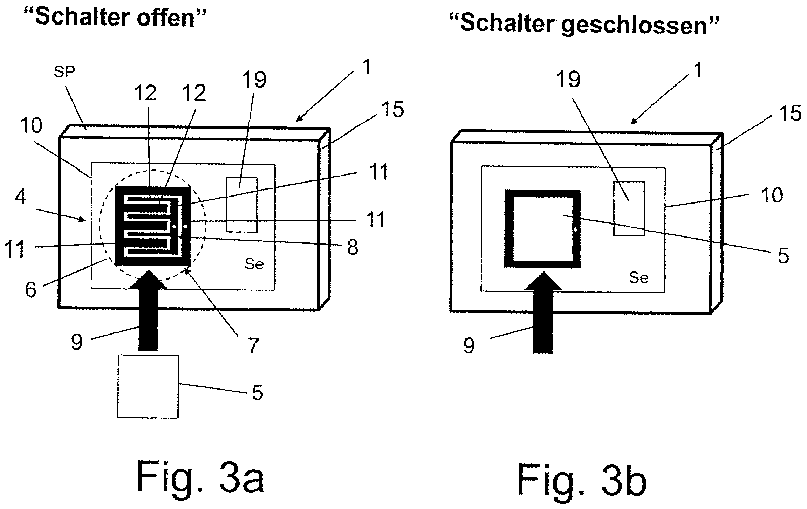

Das erfindungsgemäße Schaltelement 1, das näher in Fig. 3a zu sehen ist, umfasst einem Sensor 4 und ein bewegliches Betätigungselement 5. Das Betätigungselement 5 wirkt mit dem Sensor 4 in Bezug auf einen dem Sensor 4 zugeordneten Betätigungsbereich 6 zur Erzeugung eines Signals in der Art eines Schaltsignals zusammen. Der Sensor 4 ist als ein kapazitiver Sensor ausgebildet und umfasst zwei Elektroden 7, 8. An die Elektroden 7, 8 ist eine elektrische Spannung anlegbar, derart dass die Elektroden 7, 8 einen elektrischen Kondensator ausbilden. Das Betätigungselement 5 ist in Richtung des Pfeils 9 aus einer Stellung außerhalb des Betätigungsbereichs 6 gemäß Fig. 3a in eine Stellung innerhalb des Betätigungsbereichs 6 gemäß Fig. 3b bewegbar. Die aufgrund der Bewegung des Betätigungselements 5 in den Betätigungsbereich 6 und/oder aus den Betätigungsbereich 6 bewirkte Kapazitätsänderung des von den Elektroden 7, 8 gebildeten Kondensators ist zur Erzeugung des Schaltsignals auswertbar. Mit anderen Worten wird die Kapazitätsänderung des von den Elektroden 7, 8 gebildeten Kondensators aufgrund der Bewegung des Betätigungselements 5 relativ zum Betätigungsbereich 6 zur Erzeugung des Signals ausgewertet.

Die Elektroden 7, 8 sind als elektrische Leiterbahnen und/oder Leiterflächen ausgebildet. Die elektrischen Leiterbahnen und/oder Leiterflächen für die Elektroden 7, 8 befinden sich auf einer Leiterplatte 10. Anstelle einer Leiterplatte 10 kann auch ein sonstiger Träger, beispielsweise ein Kunststoff-Teil, das mit Leiterbahnen und/oder Leiterflächen in MID(Molded Interconnect Devices)-Technologie beschichtet ist, Verwendung finden, was jedoch nicht weiter gezeigt ist. Das Betätigungselement 5 ist als ein flächenhaftes Element ausgebildet. Beispielsweise kann das Betätigungselement 5 von rechteckförmiger Gestalt sein. Des Weiteren besteht das Betätigungselement 5 aus Kunststoff und/oder aus Metall. Das Betätigungselement 5 kann an dem Bauteil, dessen Position und/oder Bewegung zu detektieren ist, angelenkt sein. Des Weiteren ist es auch möglich, dass das Betätigungselement 5 von dem bewegbaren, zu detektierenden Bauteil selbst gebildet ist.

In einer ersten Ausführung umfasst die Elektrode 7, 8 eine im Wesentlichen geradlinige Leiterbahn 11. Von der im Wesentlichen geradlinigen Leiterbahn 11 geht mindestens ein Leiterbahnabschnitt 12 in der Art eines Zahns ab. Und zwar steht der Leiterbahnabschnitt 12 bevorzugterweise im Wesentlichen senkrecht zur geradlinigen Leiterbahn 11 ab. In bevorzugter Weise sind mehrere Leiterbahnabschnitte 12 vorgesehen, so dass die geradlinige Leiterbahn 11 mit den Leiterbahnabschnitten 12 eine Art von Kamm ausbildet. Die beiden Elektroden 7, 8 sind dabei mit in die Zwischenräume gegenseitig ineinandergreifenden Leiterbahnabschnitten 12 angeordnet. Mit anderen Worten sind die beiden Elektroden 7, 8 verzahnt miteinander angeordnet, so dass die gewünschte Kapazität ausgebildet ist. Dabei bestimmt der Abstand der beiden Elektroden 7, 8 die Höhe bzw. die Größe des elektrischen Feldes vertikal zur Ebene des Sensors 4, welche relevant für das Zusammenwirken zwischen dem Sensor 4 und dem Betätigungselement 5 ist.

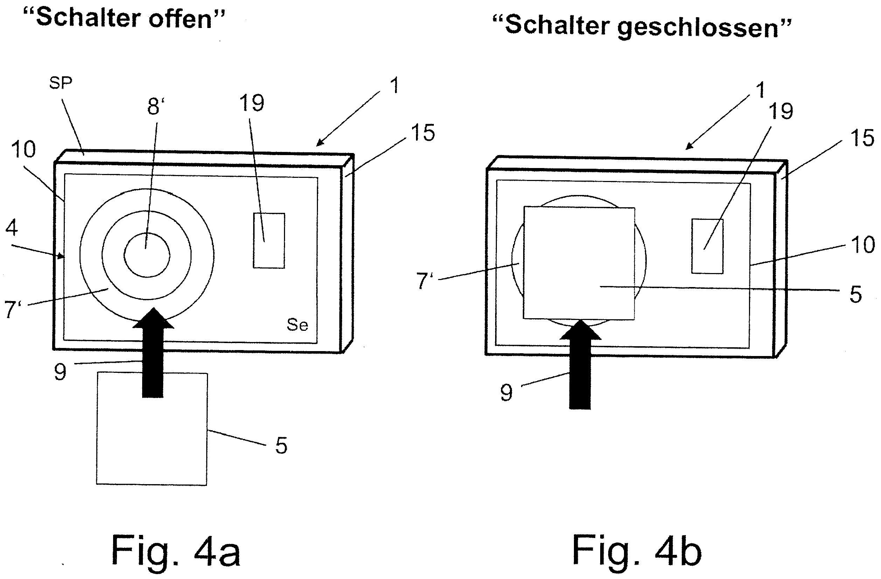

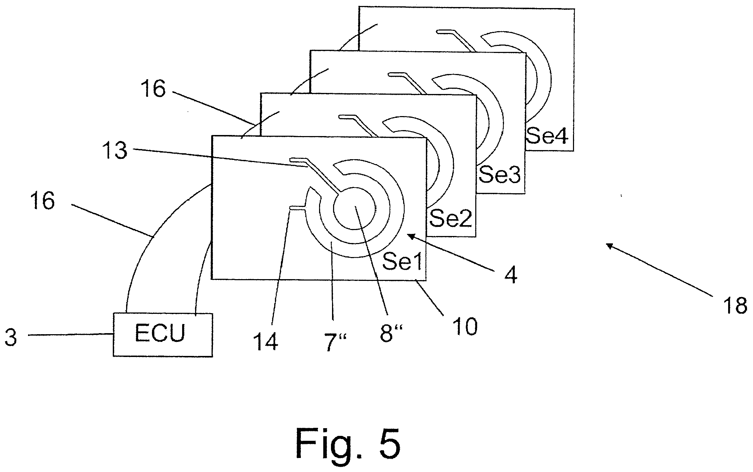

In einer weiteren zweiten Ausführung, die in Fig. 4a zu sehen ist, umfasst die Elektrode 7' eine kreisförmige elektrische Leiterbahn sowie die Elektrode 8' eine kreisflächenförmige elektrische Leiterfläche. Die beiden Elektroden 7', 8' sind konzentrisch zueinander angeordnet. Das Betätigungselement 5 ist wiederum aus der Stellung gemäß Fig. 4a in Zusammenwirkung mit dem Sensor 4 gemäß Fig. 4b in Richtung des Pfeils 9 bewegbar. In nochmals einer weiteren Ausführung, welche in Fig. 5 zu sehen ist, ist die Elektrode 7" kreisabschnittsförmig ausgebildet. Durch die so gebildete Öffnung an der Elektrode 7" ist die Kontaktierung 13 für die kreisflächenförmige Leiterbahn der Elektrode 8" hindurchgeführt. Die Elektrode 7" ist mit einer Kontaktierung 14 versehen, so dass mittels der Kontaktierungen 13, 14 die elektrische Spannung an die Elektroden 7", 8" anlegbar ist. Die beiden Elektroden 7", 8" sind wiederum konzentrisch zueinander angeordnet.

Wie weiter in Fig. 3a zu sehen ist, besitzt das Schaltelement 1 ein Gehäuse 15, das vorliegend durchsichtig dargestellt ist, damit das Innere des Schaltelements 1 sichtbar ist. Das Gehäuse 15 ist insbesondere in der Gestalt bzw. mit der Form und/oder in der Art eines Mikro- und/oder Schnappschalters ausgebildet. Die Leiterplatte 10 und/oder der Träger für die Elektroden 7, 8 ist im Inneren des Gehäuses 15 angeordnet. Das Betätigungselement 5 kann aufgrund des kapazitiven Zusammenwirkens zwischen dem Sensor 4 und dem Betätigungselement 5 außerhalb des Gehäuses 15 befindlich sein, so dass das Gehäuse 15 staub- und/oder wasserdicht ausgebildet werden kann. Falls gewünscht, ist jedoch selbstverständlich auch die Anordnung des Betätigungselements 5 innerhalb des Gehäuses 15 möglich.

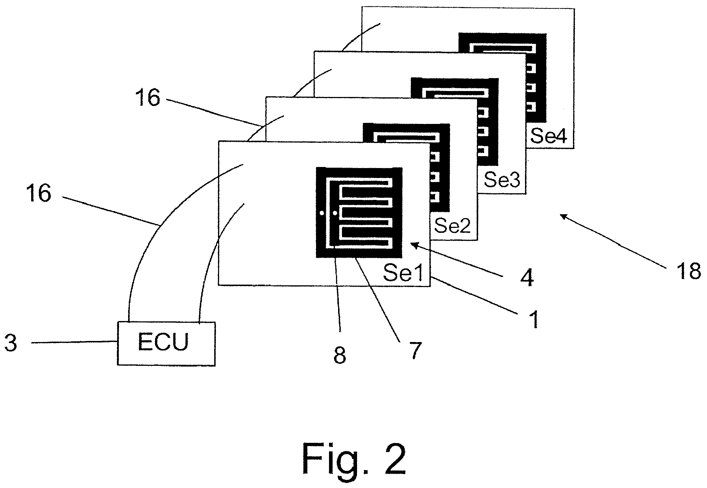

De Sensor 4 umfasst weiterhin eine Schaltungsanordnung 19 für die Messung der Kapazität des von den Elektroden 7, 8 ausgebildeten Kondensators, wobei die ebenfalls auf der Leiterplatte 10 befindliche Schaltungsanordnung 19 für die Messung der Kapazität in Fig. 3a, Fig. 3b lediglich schematisch dargestellt ist. Die Schaltungsanordnung 19 für die Messung der Kapazität steht mit der bereits erwähnten, in Fig. 2 gezeigten Elektronik 3 in elektrischer Verbindung. Die Elektronik 3 dient in der Art einer Auswerteschaltung für die Ermittlung der Kapazitätsänderung des Sensors 4 aufgrund der Bewegung des Betätigungselements 5 und/oder zur Erzeugung des Signals. Zweckmäßigerweise kann es sich bei der Elektronik 3 um einen Mikroprozessor handeln. Anstelle der Anordnung auf der Leiterplatte 10 kann die Schaltungsanordnung 19 für die Messung der Kapazität auch in die Elektronik 3 integriert sein, was jedoch nicht weiter gezeigt ist. Schließlich kann die Elektronik 3 bedarfsweise außerhalb und/oder innerhalb des Gehäuses 15 angeordnet sein.

Wie in Fig. 2 oder Fig. 5 gezeigt ist, können mehrere Schaltelemente 1 bzw. mehrere Sensoren 4 zu einer Schalteranordnung 18 elektrisch mit der von der Elektronik 3 gebildeten Auswerteschaltung verbunden sein. Dabei genügt es in den meisten Fällen, eine einzige Elektronik 3 in der Art eines Steuergeräts bzw. einer Electronic Control Unit (ECU) als Auswerteschaltung für die Schaltelemente 1 vorzusehen. Zur Einsparung der Vielzahl der in Fig. 1 gezeigten elektrischen Leitungen 2 sowie der notwendigen Schnittstellen (Interfaces) für den Anschluss der Leitungen 2 kann, wie in Fig. 2 oder Fig. 5 zu sehen ist, in bevorzugter Weise eine BUS-Anbindung 16 der Schaltelemente 1 mit der Elektronik 3 vorgesehen sein. Die Schaltelemente 1 stehen mittels des Bussystems 16 untereinander und/oder mit der Elektronik 3, die extern in Bezug auf die Schaltelemente 1 angeordnet ist, in Verbindung. Zweckmäßigerweise ist in diesem Fall eine eigene Intelligenz im Sensor 4 für dessen Kalibrierung und für die Messung der Kapazität sowie zur Ausgabe der Identifikation (ID) des jeweiligen Sensors 4 vorgesehen.

Die Erfindung ist nicht auf die beschriebenen und dargestellten Ausführungsbeispiele beschränkt. Sie umfasst vielmehr auch alle fachmännischen Weiterbildungen im Rahmen der durch die Patentansprüche definierten Erfindung. So kann das erfindungsgemäße Schaltelement nicht nur in Kraftfahrzeug-Anwendungen, wie in Türschlössern, bei Faltdächern von Cabrio-Fahrzeugen, bei Kofferraumabdeckungen, bei Sitzzustandserkennungen, bei Schiebedächern o. dgl., Verwendung finden, sondern kann auch in Hausgeräten, Audiogeräten, Videogeräten, Telekommunikationsgeräten o. dgl. in vielfältiger Weise zum Einsatz kommen.

### Bezugszeichen-Liste:

- 1:: Schaltelement
- 1':: (herkömmliches) Schaltelement
- 2:: (elektrische) Leitung (für Schaltelement)
- 3:: Elektronik
- 4:: Sensor
- 5:: Betätigungselement
- 6:: Betätigungsbereich
- 7,8:: Elektrode (von Sensor)
- 7',8':: Elektrode (weitere Ausführung)
- 7",8":: Elektrode (nochmals weitere Ausführung)
- 9:: Pfeil (Bewegung von Betätigungselement)
- 10:: Leiterplatte
- 11:: (geradlinige) Leiterbahn
- 12:: Leiterbahnabschnitt
- 13,14:: Kontaktierung (von Elektrode)
- 15:: Gehäuse
- 16:: BUS-Anbindung (von Schaltelement) / Bussystem
- 17:: (elektrisches) Kontaktsystem
- 18:: Schalteranordnung
- 18' :: (herkömmliche) Schalteranordnung
- 19:: Schaltungsanordnung für die Messung der Kapazität

## Patentansprüche

1. Schaltelement, insbesondere für ein Kraftfahrzeug, mit einem Sensor (4) und mit einem beweglichen Betätigungselement (5), wobei das Betätigungselement (5) mit dem Sensor (4) in Bezug auf einen dem Sensor (4) zugeordneten Betätigungsbereich (6) zur Erzeugung eines Signals in der Art eines Schaltsignals zusammenwirkt, **dadurch gekennzeichnet, dass** der Sensor (4) als ein kapazitiver Sensor ausgebildet ist, dass der Sensor (4) zwei Elektroden (7, 8) umfasst, wobei eine elektrische Spannung an die Elektroden (7, 8) zur Ausbildung eines elektrischen Kondensators anlegbar ist, und dass die Kapazitätsänderung des von den Elektroden (7, 8) gebildeten Kondensators aufgrund der Bewegung des Betätigungselements (5) relativ zum Betätigungsbereich (6) zur Erzeugung des Signals auswertbar ist.

2. Schaltelement nach Anspruch 1, **dadurch gekennzeichnet, dass** das Signal bei der Bewegung des Betätigungselements (5) in den Betätigungsbereich (6) und/oder innerhalb des Betätigungsbereichs (6) oder bei der Bewegung des Betätigungselements (5) aus dem Betätigungsbereich (6) und/oder außerhalb des Betätigungsbereichs (6) erzeugt wird.

3. Schaltelement nach Anspruch 1 oder 2, **dadurch gekennzeichnet, dass** die Elektroden (7, 8) als elektrische Leiterbahnen und/oder Leiterflächen ausgebildet sind, und dass vorzugsweise die elektrischen Leiterbahnen und/oder Leiterflächen auf einem Träger, insbesondere auf einer Leiterplatte (10), befindlich sind.

4. Schaltelement nach Anspruch 1, 2 oder 3, **dadurch gekennzeichnet, dass** die Elektrode (7, 8) eine im Wesentlichen geradlinige Leiterbahn (11) umfasst, dass vorzugsweise von der im Wesentlichen geradlinigen Leiterbahn (11) mindestens ein Leiterbahnabschnitt (12) in der Art eines Zahns, bevorzugterweise im Wesentlichen senkrecht abstehend, abgeht, insbesondere derart dass die geradlinige Leiterbahn (11) mit dem Leiterbahnabschnitt (12) eine Art von Kamm ausbildet, und dass weiter vorzugsweise die beiden Elektroden (7, 8) mit gegenseitig ineinandergreifenden Leiterbahnabschnitten (12) angeordnet sind.

5. Schaltelement nach einem der Ansprüche 1 bis 4, **dadurch gekennzeichnet, dass** die Elektrode (7', 8', 7", 8") eine kreisförmige und/oder kreisabschnittsförmige und/oder kreisflächenförmige Leiterbahn und/oder Leiterfläche umfasst, und dass vorzugsweise die beiden Elektroden (7', 8', 7", 8") konzentrisch zueinander angeordnet sind.

6. Schaltelement nach einem der Ansprüche 1 bis 5, **dadurch gekennzeichnet, dass** das Betätigungselement (5) als ein flächenhaftes, insbesondere rechteckförmiges, Element ausgebildet ist, und dass vorzugsweise das Betätigungselement (5) aus Kunststoff und/oder aus Metall besteht.

7. Schaltelement nach einem der Ansprüche 1 bis 6, **dadurch gekennzeichnet, dass** ein Gehäuse (15), das insbesondere in der Art und/oder mit der Form eines Mikro- und/oder Schnappschalters ausgebildet ist, vorgesehen ist, dass vorzugsweise der Träger, insbesondere die Leiterplatte (10), im Inneren des Gehäuses (15) angeordnet ist, und dass weiter vorzugsweise das Betätigungselement (5) innerhalb und/oder außerhalb des Gehäuses (15) befindlich ist.

8. Schaltelement nach einem der Ansprüche 1 bis 7, **dadurch gekennzeichnet, dass** der Sensor (4) eine Schaltungsanordnung (19) für die Messung der Kapazität des von den Elektroden (7, 8, 7', 8', 7", 8") ausgebildeten Kondensators umfasst, und dass vorzugsweise die Schaltungsanordnung (19) für die Messung der Kapazität mit einer Elektronik (3) in der Art einer Auswerteschaltung für die Ermittlung der Kapazitätsänderung und/oder zur Erzeugung des Signals in Verbindung steht.

9. Schaltelement nach einem der Ansprüche 1 bis 8, **dadurch gekennzeichnet, dass** es sich bei der Elektronik (3) um einen Mikroprozessor handelt, dass vorzugsweise die Schaltungsanordnung (19) für die Messung der Kapazität in die Elektronik (3) integriert ist, und dass weiter vorzugsweise die Elektronik (3) außerhalb und/oder innerhalb des Gehäuses (15) angeordnet ist.

10. Schalteranordnung umfassend mehrere Schaltelemente (1), **dadurch gekennzeichnet, dass** die Schaltelemente (1) nach einem der vorstehenden Ansprüche ausgebildet sind, dass vorzugsweise eine einzige Elektronik (3) in der Art eines Steuergeräts (ECU / Electronic Control Unit) als Auswerteschaltung für die Schaltelemente (1) vorgesehen ist, und dass weitere vorzugsweise die Schaltelemente (1) mittels eines Bussystems (16) untereinander und/oder mit der, insbesondere extern in Bezug auf die Schaltelemente (1) angeordneten, Elektronik (3) in Verbindung stehen.
